# EUROPÄISCHE PATENTANMELDUNG

(11) **EP 1 113 488 A2**
(43) Veröffentlichungstag der Anmeldung: **04.07.2001**
(21) Anmeldenummer: 00128275.5
(22) Anmeldetag: 22.12.2000
(51) Int. Cl.: H01L 21/3105

(54) **Verfahren zum Herstellen einer strukturierten metalloxidhaltigen Schicht**

(30) Priorität: 28.12.1999 DE 19963500
(71) Anmelder: Infineon Technologies AG, 81669 München (DE)
(72) Erfinder: Hartner, Walter, 81829 München (DE); Schindler, Günther, 80802 München (DE); Weinrich, Volker, 81373 München (DE); Ahlstedt, Mattias, 2611BJ Delft (NL)
(74) Vertreter: Graf Lambsdorff, Matthias, Dr.

(57) **Zusammenfassung**

Die bei der Strukturierung einer metalloxidhaltigen Schicht (32) auftretenden Schädigungen von Randabschnitten (32A) können durch Abscheidung einer Ausheilungsschicht (34) und einen anschließenden Wärmebehandlungsschritt kompensiert werden, durch den ein Materialfluß von der Ausheilungsschicht (34) in die geschädigten Randabschnitte (32A) stattfindet. Die metalloxidhaltige Schicht (32) kann das Dielektrikum eines Speicherkondensators (3) einer DRAM-Speicherzelle bilden.

## Beschreibung

Die Erfindung betrifft ein Verfahren zum Herstellen einer strukturierten metalloxidhaltigen Schicht gemäß Patentanspruch 1. Insbesondere betrifft die Erfindung die Herstellung einer strukturierten metalloxidhaltigen Schicht, die als ferroelektrisches oder paraelektrisches Dielektrikum in einem Speicherkondensator einer DRAM-Speicherzelle Verwendung findet.

Die in der Mikroelektronik hergestellten dynamischen Halbleiterspeicher-Bauelemente (DRAMs) bestehen im wesentlichen aus einem Auswahl- oder Schalttransistor und einem Speicherkondensator, in welchem zwischen zwei Kondensatorplatten ein dielektrisches Material eingefügt ist. Als Dielektrikum werden üblicherweise zumeist Oxid- oder Nitridschichten verwendet, die eine Dielektrizitätskonstante von maximal etwa 8 aufweisen. Zur Verkleinerung des Speicherkondensators sowie zur Herstellung von nicht-flüchtigen Speichern werden "neuartige" Kondensatormaterialien, wie beispielsweise ferroelektrische oder paraelektrische Materialien mit deutlich höheren Dielektrizitätskonstanten, benötigt. Ein paar dieser Materialien sind in der Publikation "Neue Dielektrika für Gbit-Speicherchips" von W. Hönlein, Phys. Bl. 55 (1999), genannt. Zur Herstellung von ferroelektrischen Kondensatoren für Anwendungen in derartigen nicht-flüchtigen Halbleiterspeicher-Bauelementen hoher Integrationsdichte können z.B. ferroelektrische Materialien, wie SrBi₂ (Ta, Nb)₂O₉ (SBT oder SBTN), Pb (Zr, Ti)O₃ (PZT) , oder Bi₄Ti₃O₁₂ (BTO) als Dielektrikum zwischen den Kondensatorplatten eingesetzt werden. Es kann aber auch ein paraelektrisches Material, wie beispielsweise (BaSr) TiO₃ (BST), zum Einsatz kommen.

Die Verwendung dieser neuartigen ferroelektrischen oder paraelektrischen Dielektrika stellt jedoch die Halbleiterprozeßtechnologie vor neue Herausforderungen. Zunächst lassen sich diese neuartigen Materialien nämlich nicht mehr mit dem traditionellen Elektrodenmaterial Polysilizium kombinieren. Deshalb müssen inerte Elektrodenmaterialien, wie beispielsweise Platinmetalle, d.h. Pt, Pd, Ir, Rh, Ru oder Os, oder deren leitfähige Oxide (z.B. RuO₂), eingesetzt werden. Es können auch allgemein leitfähige Oxide, wie LaSrCoOx oder SrRuO₃, verwendet werden. Der Grund hierfür liegt darin, daß nach dem Abscheiden des ferroelektrischen Dielektrikums dieses in einer sauerstoffhaltigen Atmosphäre bei Temperaturen von etwa 550 - 800°C gegebenenfalls mehrfach getempert ("konditioniert") werden muß. Zur Vermeidung von unerwünschten chemischen Reaktionen des ferroelektrischen Dielektrikums mit den Elektroden werden diese daher zumeist aus Platin oder einem anderen ausreichend temperaturstabilen und inerten Material, wie einem anderen Platinmetall oder einem leitfähigen Oxid, gefertigt.

Bei der Herstellung des Speicherkondensators sind Strukturierungsschritte notwendig, bei welchen die ferroelektrische Schicht durch einen Ätzschritt zum Teil abgetragen wird. Dabei hat es sich gezeigt, daß die stehengebliebenen Randbereiche der ferroelektrischen Schicht in bestimmter Weise geschädigt werden. Insbesondere zeigte sich, daß die stöchiometrische Zusammensetzung von SBT-Schichten in den Randabschnitten von der ursprünglichen stöchiometrischen Zusammensetzung abweicht und einen Unterschuß an Wismuth aufweist. Von der Fa. SAMSUNG ist ein naßchemisches Verfahren bekannt, bei welchem nach dem Ätzschritt die geschädigten Bereiche um den aus PZT-Material gefertigten Speicherkondensator abgetragen werden. Dies führt jedoch zu einem unerwünschten Verlust an Schichtmaterial der ferroelektrischen Schicht und somit zu einem Verlust an Speicherkapazität des herzustellenden Speicherkondensators.

Der vorliegenden Erfindung liegt demgemäß die Aufgabe zugrunde, ein Verfahren zum Herstellen einer strukturierten, metalloxidhaltigen Schicht anzugeben, bei welchem während der Strukturierung aufgetretene Schädigungen der metalloxidhaltigen Schicht ohne einen Materialverlust kompensiert werden können.

Diese Aufgabe wird durch die Merkmale des Patentanspruchs 1 gelöst.

Dementsprechend beschreibt die vorliegende Erfindung ein Verfahren zum Herstellen einer strukturierten, metalloxidhaltigen Schicht mit den Verfahrensschritten:
- Bereitstellen eines Substrats;
- Aufbringen einer metalloxidhaltigen Schicht auf das Substrat;
- Strukturieren der metalloxidhaltigen Schicht;
- Aufbringen einer die metalloxidhaltige Schicht zumindest auf Randabschnitten bedeckenden Ausheilungsschicht, welche mindestens ein Element enthält, das auch in der metalloxidhaltigen Schicht enthalten ist, aufgrund der Strukturierung jedoch in Randabschnitten einen Unterschuß in der stöchiometrischen Zusammensetzung aufweist, und
- Durchführen einer Wärmebehandlung derart, daß eine Diffusion des Elements von der Ausheilungsschicht in geschädigte Bereiche der Randabschnitte der metalloxidhaltigen Schicht stattfindet.

Das erfindungsgemäße Verfahren kann an einer freistehenden metalloxidhaltigen Schicht durchgeführt werden, wobei die Ausheilungsschicht die metalloxidhaltige Schicht vorzugsweise gänzlich bedeckt, somit jedenfalls auf den Randabschnitten aufliegt. Es kann jedoch auch vor dem Strukturieren auf die metalloxidhaltige Schicht eine weitere Schicht aufgebracht worden sein und beide Schichten gemeinsam strukturiert worden sein, wobei die Ausheilungsschicht anschließend auf die weitere Schicht und die metalloxidhaltige Schicht derart aufgebracht wird, daß die Ausheilungsschicht zumindest einen lateralen Randabschnitt der metalloxidhaltigen Schicht bedeckt. Dabei kann die metalloxidhaltige Schicht das Dielektrikum eines Speicherkondensators bilden, die weitere Schicht kann die obere Elektrode des Speicherkondensators bilden und das Substrat kann von der unteren Elektrode des Speicherkondensators gebildet sein.

Anschließend kann die Ausheilungsschicht von der metalloxidhaltigen Schicht und gegebenenfalls der weiteren Schicht entfernt werden. Sie kann jedoch auch auf der metalloxidhaltigen Schicht und gegebenenfalls der weiteren Schicht zurückgelassen werden, wobei jedoch gegebenenfalls für Zwecke der Kontaktierung der weiteren Schicht Kontaktlöcher durch die Ausheilungsschicht geätzt werden müssen. Insbesondere wenn die weitere Schicht als obere Elektrode eines Speicherkondensators dienen soll, kann es notwendig werden, ein Kontaktloch durch die Ausheilungsschicht zu formen.

Der Wärmebehandlungsschritt wird vorzugsweise in einem Temperaturbereich von 500 - 800°C, für eine Zeitdauer von 5 bis 30 min. und in O₂- oder N₂-Atmosphäre durchgeführt.

Vorzugsweise für die Zwecke der Herstellung eines Speicherkondensators für eine DRAM-Speicherzelle wird die metalloxidhaltige Schicht durch ein ferroelektrisches oder ein paraelektrisches Material gebildet. Im erstgenannten Fall enthält die metalloxidhaltige Schicht vorzugsweise eines der Materialien SrBi₂ (Ta, Nb)₂O₉ (SBT oder SBTN), Pb (Zr, Ti)O₃ (PZT) oder Bi₄Ti₃O₁₂ (BTO). Im zweitgenannten Fall enthält die metalloxidhaltige Schicht beispielsweise das Material (BaSr) TiO₃ (BST).

Wenn die metalloxidhaltige Schicht durch das Material SBT gebildet wird, so kann die Ausheilungsschicht beispielsweise eines oder mehrere der folgenden Materialien enthalten: SBT, BiOₓ/SBT, SBT + BiOₓ, BiTiOₓ, BiTiOₓ/SBT, SBT/BiTiOₓ oder BiOₓ.

Die metalloxidhaltige Schicht und/oder die Ausheilungsschicht können mittels metallorganischer Abscheidung (MOD), metallorganischer Gasphasenabscheidung (MOCVD) oder durch einen Sputterprozeß abgeschieden werden.

Für den Fall der Herstellung eines Speicherkondensators kann als Elektrodenmaterial ein Platinmetall oder ein leitfähiges Oxid eines Platinmetalls verwendet werden.

Das erfindungsgemäße Verfahren kann in ein Verfahren zum Herstellen eines Halbleiterbauelements, insbesondere einer DRAM-Speicherzelle, eingebunden werden.

Im folgenden wird ein einziges Ausführungsbeispiel der Erfindung anhand der Zeichnungen näher erläutert. Es zeigen:
- Fig. 1: eine Querschnittsansicht einer konventionellen DRAM-Speicherzelle in zwei verschiedenen Speicherkonzepten;
- Fig. 2A-C: Querschnittsansichten eines erfindungsgemäß hergestellten Speicherkondensators nach einzelnen Verfahrensschritten gemäß eines Ausführungsbeispiels der vorliegenden Erfindung.

Beim Aufbau einer DRAM-Speicherzelle gibt es im wesentlichen zwei verschiedene Strukturkonzepte, denen gemeinsam ist, daß der Schalttransistor in einer unteren Ebene unmittelbar auf dem Halbleitersubstrat geformt ist und der Speicherkondensator in einer oberen Ebene angeordnet ist, wobei beide durch eine dazwischenliegende Isolationsschicht voneinander getrennt sind.

Gemäß dem ersten Strukturkonzept ("stacked cell") sind der Schalttransistor und der Speicherkondensator im wesentlichen direkt übereinander angeordnet, wobei die untere Elektrode der Speicherkondensators mit dem Drain-Gebiet des MOS-Transistors durch ein mit einem leitfähigen Material gefülltes Kontaktloch ("plug") durch die Isolationsschicht elektrisch miteinander verbunden ist.

Gemäß dem zweiten Strukturkonzept ("offset cell") sind der Schalttransistor und der Speicherkondensator voneinander versetzt angeordnet, wobei die obere Elektrode des Speicherkondensators durch zwei Kontaktlöcher mit dem Drain-Gebiet des MOS-Transistors elektrisch verbunden ist.

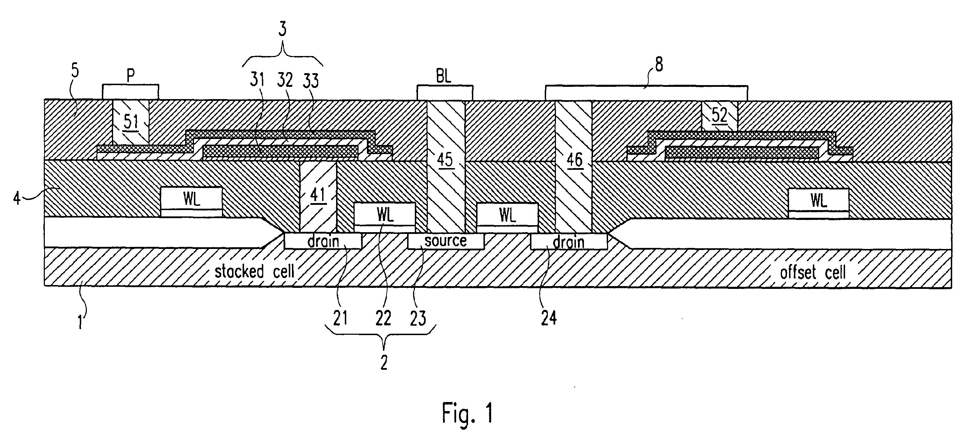

In Fig. 1 sind beide Strukturkonzepte einer konventionellen DRAM-Speicherzelle lediglich aus Gründen der vereinfachten Darstellung in einem einzigen Bauelement vereint dargestellt. Im folgenden wird die Bauelementstruktur anhand der "stacked cell" näher erläutert.

Auf einem Halbleitersubstrat 1 wird zunächst ein MOS-Transistor 2 dadurch hergestellt, indem durch Dotierung ein Drain-Gebiet 21 und ein Source-Gebiet 23 gebildet werden, zwischen denen ein Kanal besteht, der durch ein über dem Kanal angeordnetes Gate 22 in seiner Leitfähigkeit gesteuert werden kann. Das Gate 22 kann durch eine Wortleitung WL des Speicherbauelements gebildet oder mit dieser verbunden sein. Das Source-Gebiet 23 ist mit einer Bitleitung BL des Speicherbauelements verbunden. Der MOS-Transistor 2 wird anschließend mit einer planarisierenden Isolationsschicht 4, beispielsweise mit einem Oxid, wie SiO₂, bedeckt. Auf dieser Isolationsschicht 4 wird ein Speicherkondensator 3 geformt, indem zuerst eine untere Elektrode 31 aufgebracht und strukturiert wird, welche mit dem Drain-Gebiet 21 des MOS-Transistors 2 durch ein mit einem leitfähigen Material, wie polykristallines Silizium, gefülltes Kontaktloch 41 elektrisch verbunden ist. Die bis hierher hergestellte Struktur stellt das Substrat im Sinne der vorliegenden Erfindung dar.

Auf dieses Substrat, d.h. auf die untere Elektrode 31, wird dann eine metalloxidhaltige Schicht 32 eines ferroelektrischen oder paraelektrischen Materials abgeschieden, welche das Kondensatordielektrikum bildet. Diese Schicht 32 reicht in lateraler Richtung über die untere Elektrode 31 hinaus und auf sie wird eine obere Elektrode 33 ganzflächig abgeschieden und strukturiert. Die erhaltene Struktur wird schließlich wiederum von einer zweiten planarisierenden Isolationsschicht 5, beispielsweise einer Oxidschicht, wie SiO₂, bedeckt. In diese wird ein weiteres Kontaktloch 51 geformt, durch die die obere Elektrode 33 des Speicherkondensators 3 mittels eines geeigneten leitfähigen Materials mit einem äußeren elektrischen Anschluß P (gemeinsame Kondensatorplatte) verbunden werden kann. Das Source-Gebiet 23 des MOS-Transistors 2 wird dadurch mit der Bitleitung BL verbunden, indem ein sich durch beide Isolationsschichten 4 und 5 erstreckendes Kontaktloch 45 gebildet und mit einem leitfähigen Material, wie polykristallinem Silizium, gefüllt wird.

Die "offset cell"-Struktur wird auf ähnliche Weise hergestellt, wobei ein sich durch beide Isolationsschichten 4 und 5 erstreckendes Kontaktloch 46 gebildet wird, um das Drain-Gebiet 24 des MOS-Transistors mittels einer leitenden Querverbindung 8 und einem weiteren, sich durch die Isolationsschicht 5 erstreckenden Kontaktloch 52 mit der oberen Elektrode des Speicherkondensators verbunden wird.

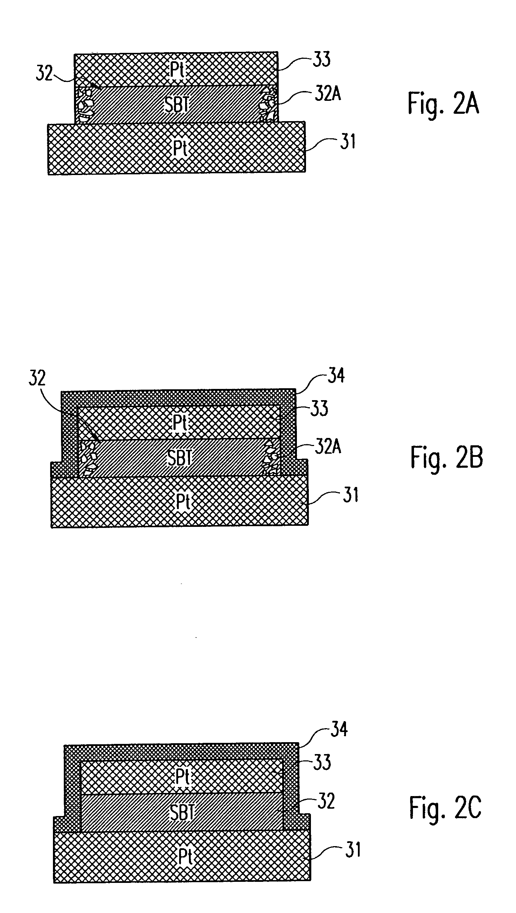

Bei beiden Speichervarianten ist es somit notwendig, die metalloxidhaltige Schicht 32 zu strukturieren. Um die dabei während der Strukturierung auftretenden Schädigungen zu kompensieren, wird das erfindungsgemäße Verfahren durchgeführt, das im folgenden anhand der Fig. 2A-C erläutert wird.

Auf eine untere Elektrode 31 aus Platin wird eine metalloxidhaltige Schicht 32, im vorliegenden Falle eine SBT-Schicht, abgeschieden. Diese Abscheidung kann wahlweise durch ein MOD (metal organic deposition)-Verfahren oder ein MOCVD (metal organic chemical vapour deposition)-Verfahren abgeschieden werden. Das SBT-Material der Schicht 32 liegt nach der Abscheidung in einem amorphen oder polykristallinen Zustand vor. Anschließend wird eine obere Elektrode 33 aus Platin auf der SBT-Schicht abgeschieden, woraufhin beide Schichten 32 und 33 durch konventionelle Photolithographie- und Ätztechnik auf eine gemeinsame Form und Größe strukturiert werden. Der Endzustand dieser Verfahrensschritte ist in Fig. 2A dargestellt. Aufgrund des Ätzschrittes weist die SBT-Schicht in ihren Randabschnitten 32A strukturelle Beeinträchtigungen auf. Insbesondere zeigt sich, daß nach dem Ätzvorgang der Wismuth-Anteil in diesen Randabschnitten 32A verringert ist. Dies geht zumeist einher mit einer Verschlechterung der elektrischen Eigenschaften der Schicht 32 und einer verringerten Speicherkapazität des Speicherkondensators 3.

In einem anschließenden Verfahrensschritt gemäß Fig. 2B wird auf die Struktur eine Wismuth-haltige Ausheilungsschicht 34 aufgebracht. Das Material dieser Ausheilungsschicht 34 kann eines oder mehrere der folgenden Materialien enthalten: SBT, BiOₓ/SBT, SBT + BiOₓ, BiTiOₓ, BiTiOₓ/SBT, SBT/BiTiOₓ. Bei Verwendung dieser Materialien ist eine Entfernung der Ausheilungsschicht 34 nach Durchführung des Verfahrens nicht oder nur unter Schwierigkeiten möglich. Für eine spätere Kontaktierung der oberen Elektrode 34 muß daher eine Kontaktöffnung durch die Ausheilungsschicht 34 geätzt werden. Alternativ kann jedoch auch beispielsweise eine reine Wismuth-Oxidschicht auf der Struktur abgeschieden werden. Dieses Material hat den Vorteil, daß es bei hoher Temperatur flüchtig ist und demnach nach Durchführung des Verfahrens von der Struktur relativ einfach wieder entfernt werden kann und somit eine nachfolgende Kontaktierung der oberen Elektrode 33 erleichtert wird.

Anschließend wird ein Wärmebehandlungsschritt mit dem Ziel durchgeführt, daß ein Materialtransport des Elements Wismuth von der Ausheilungsschicht 34 in die geschädigten Randabschnitte 32A der Schicht 32 stattfindet und somit die Randabschnitte 32A ausgeheilt werden. Dieser Wärmebehandlungsschritt kann gleichzeitig dazu dienen, die amorphe oder schwach polykristalline Schicht 32 in eine einkristalline oder großkörnige polykristalline Schicht umzuwandeln. Es kann jedoch auch vor der Strukturierung ein erster Wärmebehandlungsschritt durchgeführt worden sein, um die abgeschiedene metalloxidhaltige Schicht 32 zu kristalisieren.

Die Wärmebehandlung erfolgt bevorzugt in einem Temperaturbereich zwischen 500 und 800°C, einer Zeitdauer zwischen 5 und 30 min. und wahlweise in O₂- oder N₂-Atmosphäre. Bei Durchführung dieser Wärmebehandlung diffundiert Wismuth in die geschädigten Zonen und gleicht somit den dort vorherrschenden Wismuth-Unterschuß wieder aus. Somit werden die geschädigten Randabschnitte 32A in ihrer Stöchiometrie wiederhergestellt und die metalloxidhaltige Schicht 32 kann vollwertig zurückerhalten werden.

Bei Verwendung von Wismuthoxid kann aufgrund dessen höherer Flüchtigkeit bereits eine Temperatur ab 400°C verwendet werden.

Die Erfindung kann auch auf andere ferroelektrische Materialien ausgedehnt werden, wenn davon auszugehen ist, daß beim Ätzen oder Strukturieren der metalloxidhaltigen Schicht ein Element oder eine Komponente bevorzugt abgetragen wird, die am leichtesten flüchtig ist. Beispielsweise kann für die metalloxidhaltige Schicht 32 auch das Material PZT verwendet werden. In diesem Falle ist die flüchtige Komponente Pb, so daß nach Durchführung der Strukturierung Randabschnitte 32A der Schicht 32 vorhanden sind, die einen Unterschuß an Pb aufweisen. In diesem Fall wird für die Ausheilungsschicht 34 eine Pb-haltige Schicht auf die Struktur abgeschieden. Bei einem anschließenden Wärmebehandlungsschritt diffundiert das Element Pb der Ausheilungsschicht in geschädigte Bereiche, d.h. Randabschnitte der Schicht 32.

In ebensolcher Weise kann die vorliegende Erfindung auf andere ferroelektrische oder paraelektrische Materialien, vorzugsweise im Hinblick auf die Herstellung von Speicherkondensatoren für DRAMs, angewandt werden.

## Patentansprüche

1. Verfahren zum Herstellen einer strukturierten, metalloxidhaltigen Schicht (32) mit folgenden Verfahrensschritten:
- Bereitstellen eines Substrats;
- Aufbringen einer metalloxidhaltigen Schicht (32) auf das Substrat;
- Strukturieren der metalloxidhaltigen Schicht (32) ;
- Aufbringen einer die metalloxidhaltige Schicht (32) zumindest auf Randabschnitten (32A) bedeckenden Ausheilungsschicht (34), welche mindestens ein Element enthält, das auch in der metalloxidhaltigen Schicht (32) enthalten ist, aufgrund der Strukturierung jedoch in den Randabschnitten (32A) einen Unterschuß in der stöchiometrischen Zusammensetzung aufweist; und
- Durchführen einer Wärmebehandlung derart, daß eine Diffusion des Elements von der Ausheilungsschicht (34) in geschädigte Bereiche der Randabschnitte (32A) der metalloxidhaltigen Schicht (32) stattfindet.

2. Verfahren nach Anspruch 1,
**dadurch gekennzeichnet,** daß
- vor dem Strukturieren auf die metalloxidhaltige Schicht (32) eine weitere Schicht aufgebracht wird und beide Schichten gemeinsam strukturiert werden, und
- die Ausheilungsschicht (34) auf die weitere Schicht und die metalloxidhaltige Schicht (32) derart aufgebracht wird, daß sie zumindest einen lateralen Randabschnitt (32A) der metalloxidhaltigen Schicht (32) bedeckt.

3. Verfahren nach Anspruch 2,
**dadurch gekennzeichnet,** daß
- die metalloxidhaltige Schicht (32) das Dielektrikum eines Speicherkondensators (3) bildet,
- die weitere Schicht die obere Elektrode (33) des Speicherkondensators (3) bildet, und
- das Substrat von der unteren Elektrode (31) des Speicherkondensators (3) gebildet wird.

4. Verfahren nach einem der vorhergehenden Ansprüche,
**dadurch gekennzeichnet**, daß
- die Ausheilungsschicht (34) nach dem Wärmebehandlungsschritt von der metalloxidhaltigen Schicht (32) und gegebenenfalls der weiteren Schicht entfernt wird.

5. Verfahren nach einem der Ansprüche 1 bis 3,
**dadurch gekennzeichnet,** daß
- die Ausheilungsschicht (34) nach dem Wärmebehandlungsschritt von der metalloxidhaltigen Schicht (32) und gegebenenfalls der weiteren Schicht nicht entfernt wird.

6. Verfahren nach einem der vorhergehenden Ansprüche,
**dadurch gekennzeichnet,** daß
- die die metalloxidhaltige Schicht (32) umgebenden Schichten (31, 33) durch ein Platinmetall, d.h. Pt, Pd, Ir, Rh, Ru oder Os oder ein leitfähiges Oxid, gebildet werden.

7. Verfahren nach einem der vorhergehenden Ansprüche,
**dadurch gekennzeichnet,** daß
- der Wärmebehandlungsschritt in einem Temperaturbereich von 500 bis 800°C, für eine Zeitdauer von 5 bis 30 min. und wahlweise in O₂- oder N₂-Atmosphäre durchgeführt wird.

8. Verfahren nach einem der vorhergehenden Ansprüche,
**dadurch gekennzeichnet,** daß
- die metalloxidhaltige Schicht (32) SrBi₂(Ta, Nb)₂O₉ (SBT oder SBTN) enthält und das von der Ausheilungsschicht (34) zuzuführende Element Wismuth (Bi) ist.

9. Verfahren nach Anspruch 8,
**dadurch gekennzeichnet,** daß
- die Ausheilungsschicht (34) eines oder mehrere der folgenden Materialien enthält: SBT, BiOₓ/SBT, SBT + BiOₓ, BiTiOₓ, BiTiOₓ/SBT, SBT/BiTiOₓ oder BiOₓ.

10. Verfahren nach einem der Ansprüche 1 bis 6,
**dadurch gekennzeichnet,** daß
- die metalloxidhaltige Schicht (32) Pb (Zr, Ti)O₃ (PZT) enthält und das von der Ausheilungsschicht (34) zuzuführende Element Blei (Pb) ist.

11. Verfahren nach einem der vorhergehenden Ansprüche,
**dadurch gekennzeichnet,** daß
- die metalloxidhaltige Schicht (32) und/oder die Ausheilungsschicht (34) mittels metallorganischer Abscheidung (MOD), metallorganischer Gasphasenabscheidung (MOCVD) oder einen Sputterprozeß abgeschieden werden.

12. Verfahren zum Herstellen eines Halbleiterbauelements, insbesondere einer DRAM-Speicherzelle, bei welchem
- auf einem Halbleitersubstrat (1) ein Schalttransistor (2) geformt wird,
- auf dem Schalttransistor (2) eine erste Isolationsschicht (4) aufgebracht wird, und
- auf die Isolationsschicht (4) ein Speicherkondensator (3) geformt wird, wobei das Dielektrikum des Speicherkondensators durch Aufbringen und Strukturieren einer metalloxidhaltigen Schicht (32) nach einem der vorhergehenden Ansprüche hergestellt wird.
